# EUROPEAN PATENT APPLICATION

(11) **EP 4 564 405 A1**
(43) Date of publication of application: **04.06.2025**
(21) Application number: 24213322.1
(22) Date of filing: 15.11.2024
(51) Int. Cl.: H01L 21/311

(54) **SUBSTRATE PROCESSING METHOD AND SUBSTRATE PROCESSING APPARATUS**

(30) Priority: 30.11.2023 JP 2023202325
(71) Applicant: SCREEN Holdings Co., Ltd., Kyoto-shi, Kyoto 602-8585 (JP)
(72) Inventor: LIN, Tsung Ju, Kyoto, 602-8585 (JP); SHIBATA, Shuichi, Kyoto, 602-8585 (JP); YAMAGUCHI, Yu, Kyoto, 602-8585 (JP)
(74) Representative: Kilian Kilian & Partner mbB

(57) **Abstract**

A substrate processing method includes an ozone gas etching step of etching an amorphous carbon film in a state in which a front surface of a substrate is dry by supplying ozone gas as etching gas to the amorphous carbon film formed on the front surface of the substrate while heating the substrate and a sulfuric acid-ozone etching step of etching the amorphous carbon film by supplying, after the ozone gas is supplied to the amorphous carbon film, the amorphous carbon film with ozone-containing sulfuric acid that is sulfuric acid in which ozone gas as dissolved gas is dissolved.

## Description

### BACKGROUND OF THE INVENTION

### 1. Field of the Invention

The present invention relates to a substrate processing method and a substrate processing apparatus that process substrates. The substrates include a semiconductor wafer, a substrate for a FPD (flat panel display) such as a liquid crystal display and an organic EL (electroluminescence) display, a substrate for an optical disc, a substrate for a magnetic disk, a substrate for a magneto-optical disc, a substrate for a photomask, a ceramic substrate, a substrate for a solar cell, and the like.

### 2. Description of Related Art

JP 2023-34828 A discloses a substrate disposed in a processing chamber filled with ozone gas, the substrate being heated with a liquid film of sulfuric acid formed on the principal surface of the substrate. Paragraph [0008] of JP 2023-34828 A states that as a result, "an organic film such as a resist is rapidly and sufficiently removed from a substrate."

However, while JP 2023-34828 A mentions an organic film such as a resist, it does not refer to organic films other than resists.

At least one embodiment of the present invention provides a substrate processing method and substrate processing apparatus that can increase the etching rate for amorphous carbon films.

### SUMMARY OF THE INVENTION

An embodiment of the present invention provides a substrate processing method including an ozone gas etching step of etching an amorphous carbon film in a state in which a front surface of a substrate is dry by supplying ozone gas as etching gas to the amorphous carbon film formed on the front surface of the substrate while heating the substrate and a sulfuric acid-ozone etching step of etching the amorphous carbon film by supplying, after the ozone gas is supplied to the amorphous carbon film, the amorphous carbon film with ozone-containing sulfuric acid that is sulfuric acid in which ozone gas as dissolved gas is dissolved.

In the embodiment, at least one of the following features may be added to the substrate processing method.

The sulfuric acid-ozone etching step includes a step of supplying the ozone-containing sulfuric acid to the amorphous carbon film while heating the substrate.

The ozone gas etching step includes a step of forming an oxide film of the amorphous carbon film in a surface layer of the amorphous carbon film by oxidizing a surface of the amorphous carbon film which has been exposed by etching of the amorphous carbon film, and the sulfuric acid-ozone etching step includes a step of etching the oxide film of the amorphous carbon film by supplying the ozone-containing sulfuric acid to the amorphous carbon film.

A cycle including the ozone gas etching step and the sulfuric acid-ozone etching step is repeated a plurality of times.

The sulfuric acid-ozone etching step includes a step of forming a liquid film of the ozone-containing sulfuric acid covering the entire front surface of the substrate, by discharging sulfuric acid toward the front surface of the substrate in a state in which the substrate is held horizontally with the front surface of the substrate facing upward, and an accommodating space in which the substrate is placed is filled with ozone gas.

The sulfuric acid-ozone etching step includes a step of causing the ozone-containing sulfuric acid to remain on the front surface of the substrate while maintaining a state in which the entire front surface of the substrate is covered with the liquid film of the ozone-containing sulfuric acid.

Another embodiment of the present invention provides a substrate processing apparatus including a heater that heats a substrate having an amorphous carbon film formed on a front surface of the substrate, an ozone gas supply port that etches the amorphous carbon film while the front surface of the substrate is dry by supplying ozone gas as etching gas to the amorphous carbon film formed on the front surface of the substrate, and a nozzle that etches the amorphous carbon film by supplying, after the ozone gas is supplied to the amorphous carbon film, the amorphous carbon film formed on the front surface of the substrate with ozone-containing sulfuric acid that is sulfuric acid in which ozone gas as dissolved gas is dissolved. At least one of the above-described features regarding the substrate processing method may be added to the substrate processing apparatus.

In the embodiment, at least one of the following features may be added to the substrate processing apparatus.

The nozzle supplies the ozone-containing sulfuric acid to the amorphous carbon film when the heater is heating the substrate.

The ozone gas supply port forms an oxide film of the amorphous carbon film in a surface layer of the amorphous carbon film by oxidizing a surface of the amorphous carbon film which has been exposed by etching of the amorphous carbon film, and the nozzle etches the oxide film of the amorphous carbon film by supplying the ozone-containing sulfuric acid to the amorphous carbon film.

The ozone gas supply port and nozzle carry out a cycle, which includes etching of the amorphous carbon film by the ozone gas and etching of the amorphous carbon film by the ozone-containing sulfuric acid, a plurality of times.

The nozzle forms a liquid film of the ozone-containing sulfuric acid covering the entire front surface of the substrate by discharging sulfuric acid toward the front surface of the substrate in a state in which the substrate is held horizontally with the front surface of the substrate facing upward, and an accommodating space in which the substrate is placed is filled with ozone gas.

The nozzle causes the ozone-containing sulfuric acid to remain on the front surface of the substrate while maintaining the state in which the entire front surface of the substrate is covered with the liquid film of the ozone-containing sulfuric acid.

### BRIEF DESCRIPTION OF THE DRAWINGS

FIG. 1A to FIG. 1F are simplified cross-sectional views of a substrate to explain etching of an amorphous carbon film according to an embodiment.
FIG. 2 is a process drawing to explain etching of an amorphous carbon film according to an embodiment.
FIGs. 3A and 3B are schematic diagrams showing examples of cross-sections of a substrate before and after etching of the amorphous carbon film.
FIG. 4A is a schematic plan view showing a layout of a substrate processing apparatus according to an embodiment.
FIG. 4B is a schematic side view of the substrate processing apparatus.
FIG. 5A is a schematic diagram showing a vertical cross-section of an ozone gas etching unit.
FIG. 5B is a schematic diagram showing a vertical cross-section of an ozone gas etching unit.
FIG. 6A is a schematic diagram showing a vertical cross-section of a sulfuric acid-ozone etching unit.
FIG. 6B is a schematic diagram showing a vertical cross-section of a sulfuric acid-ozone etching unit.
FIG. 7A is a schematic diagram showing a vertical cross-section of a multi-etching unit.
FIG. 7B is a schematic diagram showing a vertical cross-section of a multi-etching unit.

### DETAILED DESCRIPTION OF PREFERRED EMBODIMENTS

Embodiments of the present invention will be explained in detail with reference to the accompanying drawings.

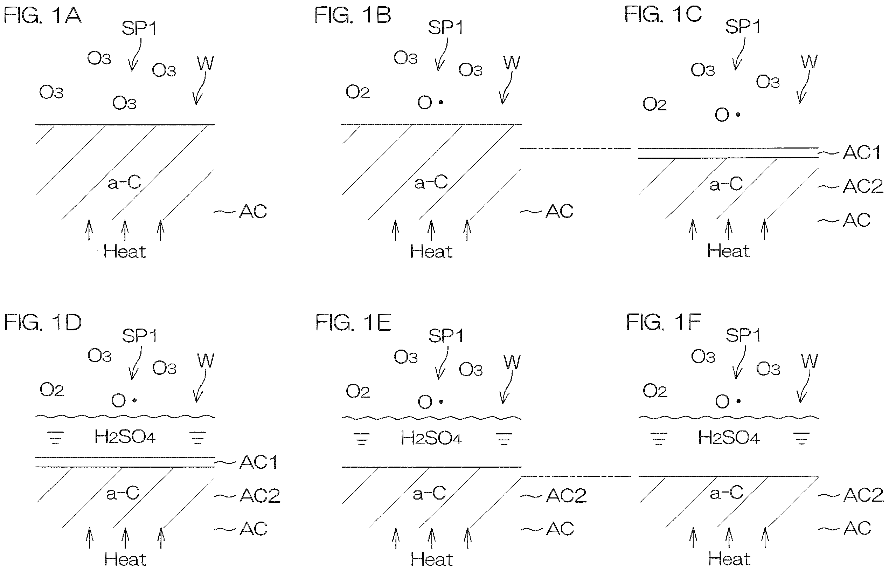

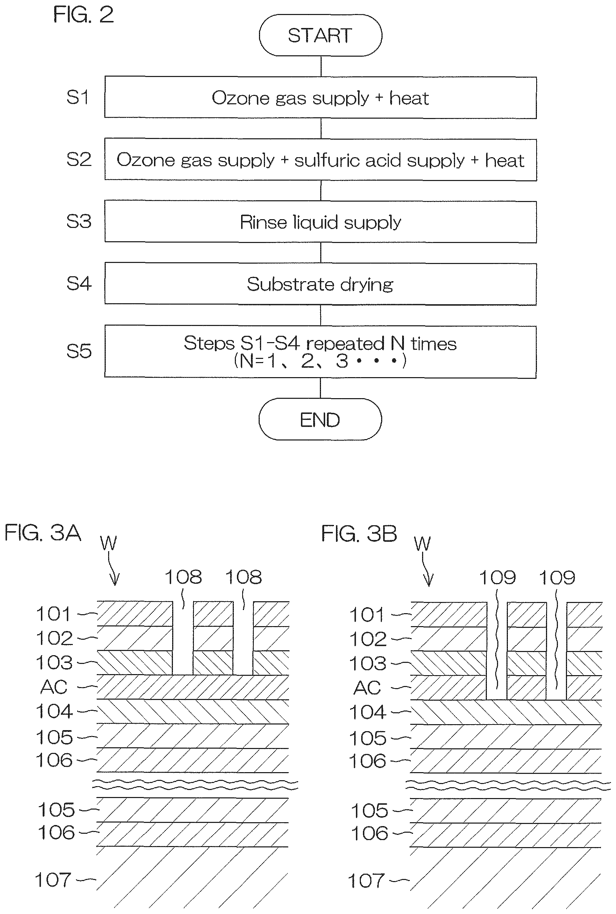

FIG. 1A to FIG. 1F are simplified cross-sectional views of a substrate W to explain etching of an amorphous carbon film AC according to an embodiment. FIG. 2 is a process drawing to explain etching of an amorphous carbon film AC according to an embodiment. The etching rate corresponds to the etching speed, which is the amount of etching per unit time.

The amorphous carbon film AC is a film composed mainly of amorphous carbon. The amorphous carbon contained in the amorphous carbon film AC may include or not include atoms other than carbon atoms, such as hydrogen atoms. The amorphous carbon contained in the amorphous carbon film AC may be amorphous carbon (a-C) having a hydrogen content of ≤5 at% (atomic percent) and an sp3 structure of 20 to 50%, or it may be amorphous carbon other than a-C.

When etching an amorphous carbon film AC exposed on the front surface of the substrate W, the following two steps are carried out: an ozone gas etching step in which ozone gas is supplied as etching gas to the substrate W to etch the amorphous carbon film AC while the substrate W is dry (Step S1 of FIG. 2), and a sulfuric acid-ozone etching step in which an SOM (Sulfuric acid and Ozone Mixture), as ozone-containing sulfuric acid, is supplied to the substrate W to etch the amorphous carbon film AC (Step S2 of FIG. 2).

When carrying out the ozone gas etching step, the substrate W is disposed horizontally within an accommodating space SP1 with the front surface of the substrate W facing upward, as shown in FIG. 1A. In this state, ozone gas is supplied as etching gas onto the upper surface of the substrate W while heating the substrate W. The accommodating space SP1 is a space formed by a tangible object such as a partition. The accommodating space SP1 may be an open space, so long as it allows the ozone gas to be supplied onto the upper surface of the substrate W at a concentration sufficient to etch the amorphous carbon film AC.

When carrying out the ozone gas etching step, the substrate W is heated at a higher temperature than room temperature (which is generally 20 to 30°C). During the ozone gas etching step, the temperature of the substrate W may be kept at a constant temperature higher than room temperature, or it may vary within a range of higher than room temperature. Heating of the substrate W may be carried out with a contact type heater that contacts the substrate W, such as a hot plate, or it may be carried out with a non-contact type heater which does not contact the substrate W, such as a lamp. For example, the substrate W may be heated while being held horizontally by contacting a hot plate with the lower surface of the substrate W. If a heated hot plate is brought adjacent to the substrate W, it is possible to heat the substrate W without contacting the hot plate with the substrate W. A hot plate is therefore an example of a non-contact type heater as well.

As shown in FIG. 1A, the accommodating space SP1 is filled with ozone gas in the ozone gas etching step to contact the ozone gas with the upper surface of the substrate W. When the ozone gas is contacted with the upper surface of the substrate W, the ozone gas may be supplied while the substrate W is stationary or the ozone gas may be supplied while rotating the substrate W around a vertical rotational axis running through the central portion of the substrate W. Supply of ozone gas to the accommodating space SP1 may be initiated simultaneously with heating of the substrate W, or it may be initiated before or after heating of the substrate W is initiated. Supply of ozone gas to the accommodating space SP1 may be carried out after or during discharge of the gas in the accommodating space SP1.

Ozone gas is gas with a higher concentration of ozone than air (for example, 0.005 ppm). The ozone molecules contained in ozone gas oxidize the amorphous carbon film AC exposed on the front surface of the substrate W. As shown in FIG. 1B, the ozone molecules contained in the ozone gas are converted to radicals with oxygen atoms, such as oxygen radicals. The radicals also cause oxidation of the amorphous carbon film AC. When two carbon atoms contained in the amorphous carbon film AC are bonded by double bonds, the oxidation may include oxidative cleavage reaction that converts the double bonds of the two carbon atoms to single bonds.

The surface layer of the amorphous carbon film AC is oxidized and gasified by chemical reaction with ozone molecules, etc., thereby separating from the amorphous carbon film AC. The heat of the substrate W may cause gasification of the oxidized amorphous carbon film AC in some cases. The gas generated by gasification of the amorphous carbon film AC, such as carbon dioxide, can be removed from the accommodating space SP1 by discharging the gas from the accommodating space SP1. The surface layer of the amorphous carbon film AC is thus removed, reducing the volume of the amorphous carbon film AC as shown in FIG. 1C.

As shown in FIG. 1C, the ozone molecules contained in the ozone gas are converted not only to radicals such as oxygen radicals but also to oxygen molecules. Oxygen molecules may be produced by chemical reaction between the radicals and the amorphous carbon film AC. When the surface of the amorphous carbon film AC is etched, a new surface of the amorphous carbon film AC is exposed and this new surface is etched. This phenomenon is continuously repeated, so that the surfaces of the amorphous carbon film AC are replaced one after another. The oxygen molecules contained in the gas in the accommodating space SP1 contact with the surface of the amorphous carbon film AC that has been exposed by etching of the amorphous carbon film AC.

When ozone gas is first supplied to the amorphous carbon film AC, the concentration of oxidizing agents such as ozone molecules and radicals is high while the concentration of oxygen is low. As the amount of etching of the amorphous carbon film AC increases, this leads to either or both reduction in the oxidizing agent concentration and/or increase in the oxygen concentration. The relative concentration of oxygen is therefore increased. When the amount of etching of the amorphous carbon film AC reaches a certain value, the etching rate of the amorphous carbon film AC falls to zero or nearly zero, and the oxygen molecules contained in the gas inside the accommodating space SP1 oxidize the surface layer of the amorphous carbon film AC. The element AC1 in FIG. 1C represents the oxide film AC1 of the amorphous carbon film AC.

At least a portion of the amorphous carbon film AC that is oxidized by the oxygen molecules contained in the gas inside the accommodating space SP1 remains on the amorphous carbon film AC without being gasified. The amorphous carbon film AC that has been oxidized by the oxygen molecules may include any one or more from among a double bonded carbon atom and oxygen atom (C=O), a single bonded carbon atom and oxygen atom (C-O) and a hydroxyl group bonded to a carbon atom (C-O-H), and it may include other types of bonded groups.

When the oxygen molecules contained in the gas inside the accommodating space SP1 oxidizes the surface layer of the amorphous carbon film AC, only the surface layer of the amorphous carbon film AC is converted to amorphous carbon oxide, with the remaining portions of the amorphous carbon film AC not being converted from amorphous carbon. Throughout the following description, the surface layer of the amorphous carbon film AC that has been converted to amorphous carbon oxide may be referred to as "the oxide film AC1 of the amorphous carbon film AC" and the remaining portions of the amorphous carbon film AC that have not been converted to amorphous carbon oxide may be referred to as "the bulk AC2 of the amorphous carbon film AC."

The ozone gas etching step is followed by the sulfuric acid-ozone etching step in which the amorphous carbon film AC is etched by supplying SOM, as ozone-containing sulfuric acid, to the substrate W. The sulfuric acid-ozone etching step may be carried out after having moved the substrate W that has passed through the ozone gas etching step, or without moving the substrate W. In other words, a chamber housing the substrate W where the sulfuric acid-ozone etching step is carried out may be the same or a different chamber from the one housing the substrate W in which the ozone gas etching step is carried out.

When carrying out the sulfuric acid-ozone etching step, SOM is supplied onto the upper surface of the substrate W while heating the substrate W that is disposed horizontally inside the accommodating space SP1, as shown in FIG. 1D. While the sulfuric acid-ozone etching step is being carried out, the temperature of the substrate W may be kept at a constant temperature higher than room temperature, or it may vary within a range of higher than room temperature. The temperature of the substrate W while the sulfuric acid-ozone etching step is being carried out (the maximum value, if the temperature varies) may be equal to the temperature of the substrate W when the ozone gas etching step is being carried out (or the maximum value, if the temperature varies), or it may be different. Heating of the substrate W may be carried out using a contact type or non-contact type heater, or both a contact type heater and a non-contact type heater.

SOM is ozone-containing sulfuric acid, or in other words, sulfuric acid containing dissolved ozone gas as dissolved gas. Unless otherwise specified, the SOM is in liquid form. The sulfuric acid used to prepare the SOM is concentrated sulfuric acid (sulfuric acid aqueous solution with a sulfuric acid concentration of 90% or greater). A sulfuric acid aqueous solution with a lower sulfuric acid concentration than concentrated sulfuric acid may be used to prepare the SOM so long as it does not prevent etching of the amorphous carbon film AC. As used hereunder, the term "sulfuric acid" refers to a sulfuric acid aqueous solution, unless otherwise specified.

The SOM is supplied onto the entirety of the upper surface of the substrate W. A liquid film of SOM is therefore formed, covering the entirety of the upper surface of the substrate W. When the SOM is supplied to the upper surface of the substrate W, the SOM may be supplied while the substrate W is stationary or the SOM may be supplied while rotating the substrate W around a vertical rotational axis running through the central portion of the substrate W. So long as the entirety of the upper surface of the substrate W is kept covered with a liquid film of SOM, the SOM may be continuously added to the upper surface of the substrate W while dispersing the SOM from the outer perimeter of the substrate W, or the SOM may be allowed to remain on the upper surface of the substrate W while stopping any addition of SOM onto the substrate W. In the latter case, the substrate W may be held still or rotated at a low speed, while the entirety of the upper surface of the substrate W is covered with SOM or sulfuric acid.

The ozone gas, as dissolved gas, may be dissolved in sulfuric acid before contacting with the substrate W or it may be dissolved in sulfuric acid contacting the substrate W. FIG. 1D shows an example of the latter case. In this example, ozone gas is filled into the accommodating space SP1 while covering the entirety of the upper surface of the substrate W with a liquid film of sulfuric acid. The ozone gas contained in the gas inside the accommodating space SP1 dissolves into the sulfuric acid, from the surface of the liquid film of sulfuric acid contacting with the upper surface of the substrate W, while diffusing inside the same liquid film. The SOM is thereby supplied to the upper surface of the substrate W.

Supply of ozone gas to the accommodating space SP1 may be initiated simultaneously when supply of sulfuric acid to the substrate W is initiated, or it may be initiated before or after supply of sulfuric acid to the substrate W is initiated. The same also applies when heating of the substrate W is initiated. Supply of ozone gas to the accommodating space SP1 may be initiated simultaneously with heating of the substrate W, or it may be initiated before or after heating of the substrate W is initiated. Supply of ozone gas to the accommodating space SP1 may be carried out after or during discharge of the gas in the accommodating space SP1.

The ozone gas as etching gas may be dissolved in the sulfuric acid that contacts with the substrate W, or separate ozone gas from the etching gas may be dissolved in the sulfuric acid that contacts with the substrate W. In the latter case, the ozone gas as dissolved gas may be supplied to the accommodating space SP1 after the ozone gas used as etching gas has been discharged from the accommodating space SP1. In this case, gas which is free or essentially free of ozone, such as inert gas or air, may be supplied to the accommodating space SP1 after the ozone gas as etching gas has been discharged from the accommodating space SP1 and before the ozone gas as dissolved gas is supplied to the accommodating space SP1.

Sulfuric acid contained in SOM dissociates into hydrogen ion and hydrogen sulfate ion, as represented by Chemical Formula 1. The SOM contains ozone molecules in addition to sulfuric acid. The hydrogen sulfate ions and ozone molecules in SOM react with each other and form water and peroxodisulfate ion, as represented by Chemical Formula 2. Since the substrate W is heated, thermal energy is added to the peroxodisulfate ion in the SOM. This causes the peroxodisulfate ions to be converted to sulfate ion radicals (also known as sulfuric acid radicals), as represented by Chemical Formula 3. The SOM contacting with the substrate W can also be irradiated with light such as ultraviolet rays in addition to or instead of heating the substrate W, for conversion of the peroxodisulfate ions to sulfate ion radicals.

[Chemical Formula 1] H₂SO₄ ⇄ H⁺ + HSO₄⁻

[Chemical Formula 2] 2HSO₄⁻ + O₃ → O₂ + H₂O + S₂O₈²⁻

[Chemical Formula 3] S₂O₈²⁻ → 2SO₄^{- .}

The SOM contacting with the substrate W includes not only ozone molecules but also radicals such as oxygen radicals. The SOM contacting with the substrate W also includes the aforementioned peroxodisulfate ions and sulfate ion radicals. When the surface layer of the amorphous carbon film AC has been converted to the oxide film AC1 of the amorphous carbon film AC by the ozone gas etching step, the oxidizing agents in the SOM, such as sulfate ion radicals, decompose the oxide film AC1 of the amorphous carbon film AC, causing it to dissolve in the SOM. This results in removal of the oxide film AC1 of the amorphous carbon film AC, and exposure of the bulk AC2 of the amorphous carbon film AC, i.e., the portion of the amorphous carbon film AC that has not been converted to the oxide of the amorphous carbon film AC, as shown in FIG. 1E. The bulk AC2 of the amorphous carbon film AC will be referred to hereunder simply as "amorphous carbon film AC."

As shown in FIG. 1F, the ozone molecules and oxygen radicals in the SOM cause oxidation of the surface layer of the amorphous carbon film AC. The oxidized amorphous carbon film AC dissolves in the SOM. This results in etching of the surface of the amorphous carbon film AC. When the surface of the amorphous carbon film AC is etched, the surface of the amorphous carbon film AC is freshly exposed, with etching taking place on the fresh surface. Continued repetition of this phenomenon causes the surface of the amorphous carbon film AC to be progressively replaced. The surface layer of the amorphous carbon film AC is thus removed, reducing the volume of amorphous carbon film AC.

The etching rate of the amorphous carbon film AC in the ozone gas etching step is greater than the etching rate of the amorphous carbon film AC in the sulfuric acid-ozone etching step. So long as the amount of etching of the amorphous carbon film AC in the ozone gas etching step is more than the amount of etching of the amorphous carbon film AC in the sulfuric acid-ozone etching step, then the etching time in the ozone gas etching step may be equal to or different from the etching time in the sulfuric acid-ozone etching step.

After etching of the amorphous carbon film AC by the SOM, the SOM is washed away with a rinse liquid such as pure water (deionized water (DIW)) (Step S3 in FIG. 2), and the substrate W is dried (Step S4 in FIG. 2). When the accommodating space SP1 is filled with ozone gas, the rinse liquid may be supplied to the substrate W while discharging the ozone gas from the accommodating space SP1, or the rinse liquid may be supplied to the substrate W before or after discharging the ozone gas from the accommodating space SP1. After the rinse liquid has been supplied to the entirety of the upper surface of the substrate W, the substrate W still having adhering liquid such as rinse liquid is dried. The method for drying the substrate W may be spin drying in which the liquid is removed from the substrate W by high-speed rotation of the substrate W, or a method other than spin drying, such as reduced pressure drying in which the liquid contacting with the substrate W is evaporated off by lowering the air pressure in the accommodating space SP1.

After the substrate W has been dried, the processing of the substrate W may be ended, or process from the ozone gas etching step (Step S1 in FIG. 2) to the drying step (Step S4 in FIG. 2) may be performed again. In other words, one cycle, including the ozone gas etching step, the sulfuric acid-ozone etching step, the rinsing step and the drying step, may be repeated a plurality of times (Step S5 in FIG. 2). When the oxide film AC1 of the amorphous carbon film AC is formed, the etching rate of the amorphous carbon film AC falls to zero or nearly zero in the ozone gas etching step. Carrying out the sulfuric acid-ozone etching step allows the oxide film AC1 of the amorphous carbon film AC to be removed. Repeating the cycle described above therefore allows etching of the amorphous carbon film AC to be accomplished in an efficient manner.

A cross-section of the substrate W on which the amorphous carbon film AC has been formed will now be described.

FIG. 3A is a schematic diagram showing an example of a cross-section of a substrate W before etching of the amorphous carbon film AC. FIG. 3B is a schematic diagram showing an example of a cross-section of a substrate W after etching of the amorphous carbon film AC. In FIG. 3A and FIG. 3B, the relative thickness of each thin-film, such as the resist film 101, is not necessarily the same as its actual relative thickness.

The amorphous carbon film AC prior to etching may be a thin-film without recessed portions recessed from the surface of the amorphous carbon film AC, or it may be a thin-film with recessed portions recessed from the surface of the amorphous carbon film AC. FIG. 3A shows an example of the former case. In the latter case, the recessed portions may penetrate through, or not penetrate through, the amorphous carbon film AC in the thickness direction of the amorphous carbon film AC (the up-down direction of the page for FIG. 3A). The recessed portions may be holes or grooves, or other shapes.

Etching of the amorphous carbon film AC illustrated in FIG. 1A to FIG. 1F may be uniform etching in which the entire amorphous carbon film AC is uniformly etched, or it may be selective etching in which only parts of the amorphous carbon film AC are etched. Selective etching may be etching in which recessed portions penetrating through the thickness direction of the amorphous carbon film AC are formed in the amorphous carbon film AC, or it may be etching in which recessed portions not penetrating through the thickness direction of the amorphous carbon film AC are formed in the amorphous carbon film AC. FIG. 3B shows an example of the former case.

The substrate W shown in FIG. 3A includes a discoid base material 107 such as a silicon wafer, and a stacked film formed on the base material 107. The stacked film may be a part that is to constitute the memory cell array of a three-dimensional NAND flash memory, for example. A memory cell array is a section including a plurality of memory cells arranged three-dimensionally in three orthogonal directions.

The stacked film includes a plurality of silicon oxide film 106 and silicon nitride film 105 pairs stacked in the thickness direction of the substrate W with the silicon oxide film 106 and silicon nitride film 105 alternating. The stacked film also includes a silicon oxide film 104 formed on the silicon oxide film 106 and silicon nitride film 105 pairs, an amorphous carbon film AC formed on the silicon oxide film 104, a silicon oxynitride film 103 formed on the amorphous carbon film AC, an antireflection film 102 formed on the silicon oxynitride film 103, and a resist film 101 formed on the antireflection film 102.

The amorphous carbon film AC is etched using the pattern of the silicon oxynitride film 103, antireflection film 102 and resist film 101 as a mask. Specifically, the silicon oxynitride film 103, antireflection film 102 and resist film 101 constitute a mask exposing the parts of the amorphous carbon film AC that are to be etched and covering the parts of the amorphous carbon film AC that are not to be etched. Portions of the amorphous carbon film AC are exposed at the bottoms of the recessed portions 108 penetrating through the silicon oxynitride film 103, etc., in the thickness direction. In etching of the amorphous carbon film AC shown in FIG. 1A to FIG. 1F, only the parts of the silicon oxynitride film 103, etc., that are not covered with the mask are etched, forming recessed portions 109 which expose the silicon oxide film 104.

A substrate processing apparatus 1 used to carry out etching of the amorphous carbon film AC shown in FIG. 1A to FIG. 1F will now be described.

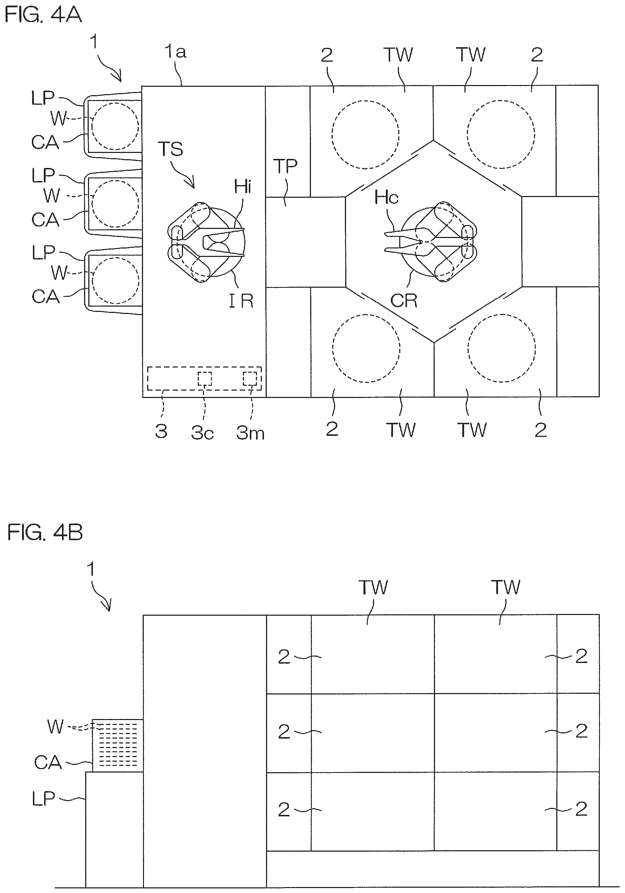

FIG. 4A is a schematic plan view showing a layout of the substrate processing apparatus 1 according to an embodiment. FIG. 4B is a schematic side view of the substrate processing apparatus 1. The substrate processing apparatus 1 is a single substrate processing type apparatus that processes disk-shaped substrates W such as semiconductor wafers one by one. The substrate processing apparatus 1 includes a load port LP that holds a carrier CA housing the substrates W, a plurality of processing units 2 that process the substrates W transferred from the carrier CA on the load port LP with a processing fluid such as a processing liquid or processing gas, a transfer system TS that transfers the substrates W between the carrier CA on the load port LP and the plurality of processing units 2, an outer wall 1a that forms a sealed space housing the plurality of processing units 2 and the transfer system TS, and a controller 3 that controls the substrate processing apparatus 1.

The plurality of processing units 2 form a plurality of towers TW. FIG. 4A shows an example where four towers TW are formed. As shown in FIG. 4B, a plurality of processing units 2 included in a single tower TW are stacked vertically. As shown in FIG. 4A, the plurality of towers TW form two rows extending in the depth direction (the left-right direction of the paper in 4A) of the substrate processing apparatus 1 in a plan view. The two rows face each other across a transport path TP in a plan view.

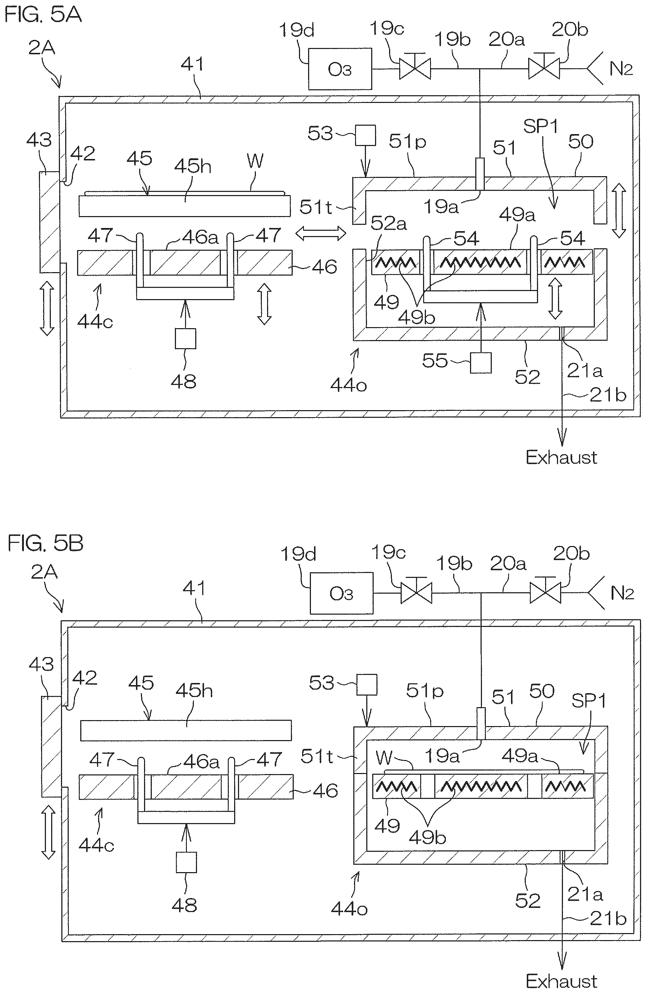

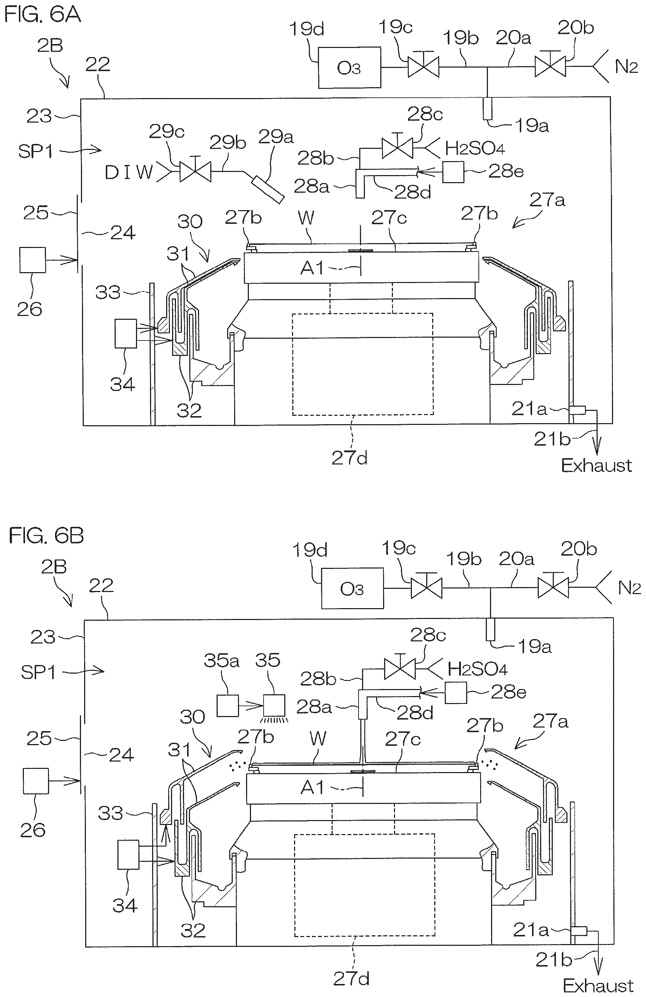

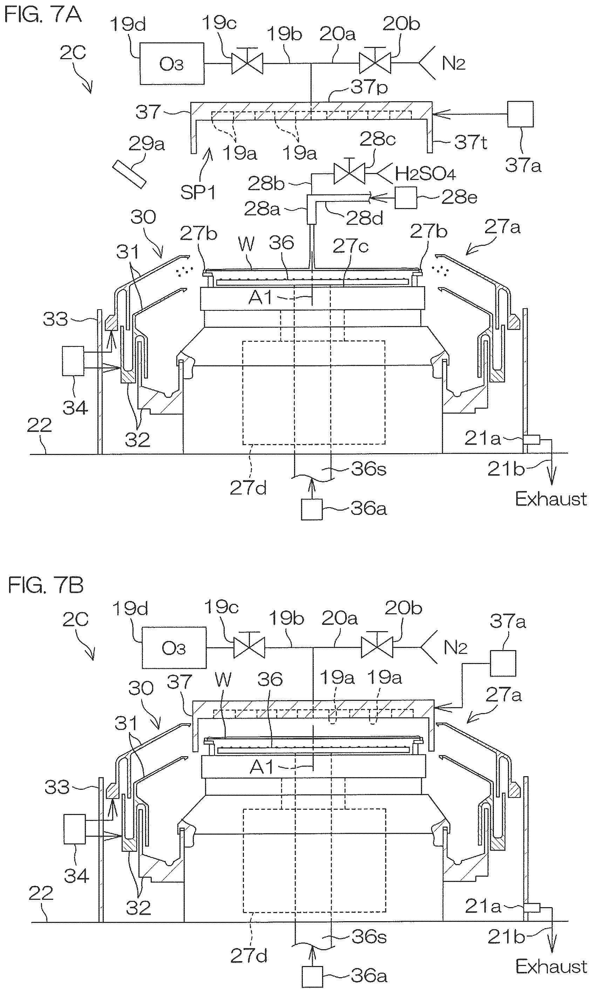

The plurality of processing units 2 may include an ozone gas etching unit 2A (see FIG. 5A) used to carry out the ozone gas etching step and a sulfuric acid-ozone etching unit 2B (see FIG. 6A) used to carry out the sulfuric acid-ozone etching step. Alternatively, at least one processing unit 2 may be a multi-etching unit 2C (see FIG. 7A) used to carry out both the ozone gas etching step and sulfuric acid-ozone etching step. The plurality of processing units 2 may include the ozone gas etching unit 2A, sulfuric acid-ozone etching unit 2B and multi-etching unit 2C.

The transport system TS includes an indexer robot IR that transports the substrate W between the carrier CA on the load port LP and the plurality of processing units 2, and a center robot CR that transports the substrate W between the indexer robot IR and the plurality of processing units 2. The indexer robot IR is disposed between the load port LP and the center robot CR, in a plan view. The center robot CR is disposed in the transport path TP.

The indexer robot IR includes one or more hands Hi that support the substrates W horizontally. The hand Hi is movable in parallel in both the horizontal direction and the vertical direction. The hand Hi is rotatable around a vertical line. The hand Hi can carry in and carry out the substrate W to and from the carrier CA on any of the load ports LP, and can receive and transfer the substrate W from and to the center robot CR.

The center robot CR includes one or more hands Hc that support the substrates W horizontally. The hand Hc is movable in parallel in both the horizontal direction and the vertical direction. The hand Hc is rotatable around a vertical line. The hand Hc can receive and transfer the substrate W from and to the indexer robot IR, and carry in and carry out the substrate W to and from any of the processing units 2.

The controller 3 controls electrical devices and electronic devices provided in the substrate processing apparatus 1. The controller 3 includes at least one computer. The computer includes a memory 3m that stores information such as a program, and a CPU 3c (Central Processing Unit) that controls the substrate processing apparatus 1 according to the program stored in the memory 3m. The controller 3 controls the substrate processing apparatus 1 to carry out transfer and processing of the substrate W described below. In other words, the controller 3 is programmed to carry out transfer and processing of the substrate W as described below.

The ozone gas etching unit 2A, sulfuric acid-ozone etching unit 2B and multi-etching unit 2C will now be described. The ozone gas etching unit 2A will be described first.

FIG. 5A and FIG. 5B are schematic diagrams showing a vertical cross-section of the ozone gas etching unit 2A. The ozone gas etching unit 2A includes a chamber 41 forming an interior space in the ozone gas etching unit 2A, a door 43 that opens and closes an outlet/inlet port 42 formed in the chamber 41, an oxidation unit 44o that supplies processing gas such as ozone gas to the substrate W while heating the substrate W in the chamber 41, a cooling unit 44c that cools the substrate W heated by the oxidation unit 44o in the chamber 41, and a local transfer robot 45 that transfers the substrate W in the chamber 41.

The cooling unit 44c and oxidation unit 44o are disposed inside the chamber 41. The cooling unit 44c is closer to the outlet/inlet port 42 than the oxidation unit 44o. A center robot CR (see FIG. 4A) carries in and out the substrate W to and from the chamber 41 through the outlet/inlet port 42. The local transfer robot 45 receives the substrate W from the center robot CR, and transfers the substrate W to the center robot CR. The local transfer robot 45 also transfers the substrate W between the cooling unit 44c and oxidation unit 44o.

The cooling unit 44c includes a cooling plate 46 that cools the substrate W, a lift pin 47 that moves up and down penetrating through the cooling plate 46, and a pin lifting/lowering actuator 48 that moves the lift pin 47 up and down. The cooling plate 46 includes a cooling surface 46a on which the substrate W is placed. Inside the cooling plate 46, there is formed a coolant channel (not shown) where the coolant (typically cooling water) circulates. The lift pin 47 moves up and down between an upper position where the substrate W is supported higher than the cooling surface 46a, and a lower position where the tip of the lift pin 47 is positioned lower than the cooling surface 46a.

The actuator is a device that converts driving energy, which represents electrical, fluid, magnetic, thermal or chemical energy, to mechanical work, that is, motion of a tangible object. The actuator includes an electric motor (rotary motor), linear motor, air cylinder and other devices. If the motion of the actuator is different from the motion of the object, a motion converter may be provided to convert the motion of the actuator into linear motion or rotation. For example, if the actuator is an electric motor and the object is to be moved in a linear motion, a motion converter, such as a ball screw and ball nut, may convert the rotation of the electric motor into linear motion.

The oxidation unit 44o includes a hot plate 49 which heats the substrate W, an inner chamber 50 that houses the hot plate 49, a lift pin 54 that moves up and down penetrating through the hot plate 49, and a pin lifting/lowering actuator 55 that moves the lift pin 54 up and down. The hot plate 49 is an example of a substrate holder. The hot plate 49 includes a heating surface 49a on which the substrate W is placed. A heating body 49b which releases heat by supply of electric power is built into the hot plate 49. When the substrate W is placed on the heating surface 49a, the substrate W is surrounded by the outer perimeter of the heating surface 49a in a plan view.

The inner chamber 50 forms the accommodating space SP1. The inner chamber 50 includes a fixed housing 52 which is fixed with respect to the chamber 41 and a hood 51 which moves up and down above the fixed housing 52. The hot plate 49 is disposed between the hood 51 and the fixed housing 52. The hood 51 includes a discoid plate portion 51p held horizontally above the hot plate 49, and a cylinder portion 51t which extends downward from the outer periphery of the plate portion 51p. The lower end of the cylinder portion 51t vertically faces the upper end of the fixed housing 52.

The oxidation unit 44o includes a hood raising/lowering actuator 53 that raises and lowers the hood 51. The fixed housing 52 has an opening 52a that is opened from above, and the opening 52a is opened and closed by the hood 51. As shown in FIG. 5B, the hood 51 moves up and down between the closed position (lower position) that forms the closed accommodating space SP1 between the hood 51 and fixed housing 52, and the open position (upper position) where the lower end of the cylinder portion 51t is separated upward from the upper end of the fixed housing 52. The lift pin 54 moves up and down between an upper position where the substrate W is supported higher than the heating surface 49a, and a lower position where the tip of the lift pin 54 is positioned lower than the heating surface 49a.

The oxidation unit 44o includes an ozone gas supply port 19a that supplies ozone gas to the accommodating space SP1. FIG. 5A and FIG. 5B show examples where the ozone gas supply port 19a is opened at the lower surface of the plate portion 51p of the hood 51. The oxidation unit 44o also includes an ozone gas generator 19d that generates ozone gas to be supplied to the ozone gas supply port 19a, an ozone gas tube 19b that guides ozone gas generated by the ozone gas generator 19d toward the ozone gas supply port 19a, and an ozone gas valve 19c that opens and closes between an open state where ozone gas flows from the ozone gas tube 19b to the ozone gas supply port 19a, and a closed state where ozone gas does not flow from the ozone gas tube 19b to the ozone gas supply port 19a.

The oxidation unit 44o further includes an exhaust port 21a that discharges gas inside the accommodating space SP1, and a discharge tube 21b that guides gas flowing into the exhaust port 21a away from the accommodating space SP1. When the ozone gas valve 19c is opened, the ozone gas flows out from the ozone gas supply port 19a and is supplied into the accommodating space SP1. Continuing supply of the ozone gas causes the accommodating space SP1 to be filled with ozone gas. Supply of ozone gas to the accommodating space SP1 may be carried out while discharging the gas in the accommodating space SP1 to the exhaust port 21a, or it may be carried out after the gas in the accommodating space SP1 has been discharged to the exhaust port 21a.

The oxidation unit 44o includes an inert gas tube 20a that guides nitrogen gas, as an example of inert gas to be supplied into the accommodating space SP1, and an inert gas valve 20b that opens and closes between an open state where nitrogen gas flows from the inert gas tube 20a into the accommodating space SP1, and a closed state where nitrogen gas does not flow from the inert gas tube 20a into the accommodating space SP1. FIG. 5A and FIG. 5B show examples in which nitrogen gas in the inert gas tube 20a is supplied into the accommodating space SP1 through the ozone gas supply port 19a. The nitrogen gas in the inert gas tube 20a may be supplied into the accommodating space SP1 through a supply port separate from the ozone gas supply port 19a.

The local transfer robot 45 includes a hand 45h that transfers the substrate W between the cooling unit 44c and oxidation unit 44o. The hand 45h is arranged to be able to deliver the substrate W between the lift pin 47 of the cooling unit 44c, and to deliver the substrate W between the lift pin 54 of the oxidation unit 44o. The hand 45h can thus operate such as to receive the substrate W from the lift pin 47 of the cooling unit 44c and deliver the substrate W to the lift pin 54 of the oxidation unit 44o. The hand 45h can also operate such as to receive the substrate W from the lift pin 54 of the oxidation unit 44o and deliver the substrate W to the lift pin 47 of the cooling unit 44c.

When carrying out the ozone gas etching step, the door 43 is situated at the open position to open the outlet/inlet port 42. In this state, the hand Hc of the center robot CR (see FIG. 4A) enters into the chamber 41, positioning the substrate W above the cooling plate 46. When this occurs, the lift pin 47 rises to the upper position, receiving the substrate W from the hand Hc of the center robot CR. The hand Hc of the center robot CR then retracts out of the chamber 41.

The hand 45h of the local transfer robot 45 then receives the substrate W from the lift pin 47 and transfers the substrate W to the lift pin 54 of the oxidation unit 44o. The hood 51 is in the open position (upper position) at this time, with the lift pin 54 supporting the received substrate W at the upper position. After the hand 45h has retreated from the inner chamber 50, the lift pin 54 falls to the lower position and places the substrate W on the heating surface 49a. On the other hand, the hood 51 is lowered to the closed position (lower position), forming a closed accommodating space SP1 that encloses the hot plate 49. The ozone gas etching step is carried out on the substrate W in this state.

In the ozone gas etching step, the substrate W is heated by the hot plate 49 while supplying ozone gas that has flowed out from the ozone gas supply port 19a onto the substrate W on the hot plate 49. Specifically, heating of the substrate W by the hot plate 49 is initiated when the lift pin 54 places the substrate W received from the hand 45h of the local transfer robot 45 onto the heating surface 49a of the hot plate 49. After the hood 51 has been placed on the closed position (lower position), ozone gas is supplied from the ozone gas supply port 19a into the accommodating space SP1, i.e., the interior space of the inner chamber 50, while gas in the accommodating space SP1 is discharged through the exhaust port 21a. This causes ozone gas to fill the accommodating space SP1 and be supplied to the substrate W on the hot plate 49. After the ozone gas etching step has been carried out, the gas in the accommodating space SP1, such as ozone gas, is discharged through the exhaust port 21a, and gas other than ozone gas, such as inert gas, is filled into the accommodating space SP1.

Once the ozone gas etching step is completed, the hood 51 rises to the open position (upper position), and the inner chamber 50 is opened. The lift pin 54 also rises to the upper position, and the substrate W is pushed upward above the heating surface 49a. In this state, The hand 45h of the local transfer robot 45 receives the substrate W from the lift pin 54 and transfers the substrate W to the lift pin 47 of the cooling unit 44c. The lift pin 47 supports the received substrate W at the upper position. After waiting for retreat of the hand 45h, the lift pin 47 falls to the lower position, whereby the substrate W is placed on the cooling surface 46a of the cooling plate 46. This causes the substrate W to be cooled.

When cooling of the substrate W is completed, the lift pin 47 rises to the upper position, thereby the substrate W is pushed upward above the cooling surface 46a. In this state, the door 43 is opened and the hand Hc of the center robot CR enters into the chamber 41 and is set below the substrate W which is being supported by the lift pin 47 at the upper position. When the lift pin 47 is lowered in this state, the substrate W is transferred to the hand Hc of the center robot CR. The hand Hc that held the substrate W then retracts out of the chamber 41, after which the door 43 closes the outlet/inlet port 42.

The sulfuric acid-ozone etching unit 2B used to carry out the sulfuric acid-ozone etching step will now be described.

FIG. 6A and FIG. 6B are schematic diagrams showing a vertical cross-section of a sulfuric acid-ozone etching unit 2B. The sulfuric acid-ozone etching unit 2B includes a chamber 22 forming the accommodating space SP1. The chamber 22 includes a partition 23 forming the accommodating space SP1, and a door 25 that opens and closes an outlet/inlet port 24 provided in the partition 23. An opening/closing actuator 26 moves the door 25 between an open position which allows the substrate W to pass through the outlet/inlet port 24, and a closed position where the outlet/inlet port 24 is closed by the door 25.

The sulfuric acid-ozone etching unit 2B includes a spin chuck 27a that rotates one substrate W in the accommodating space SP1 around a vertical rotational axis A1 running through the central portion of the substrate W, while holding it horizontally. The spin chuck 27a includes an electric motor 27d that rotates the substrate W around its rotational axis A1 while it is being held by the spin chuck 27a in a horizontal orientation.

The spin chuck 27a may be a gripping-type chuck that contacts the plurality of chuck pins 27b at the edges of substrate W, or it may be a vacuum-type chuck that holds the substrate W horizontally by adsorbing the rear surface (lower surface) of the substrate W (the non-device forming side) onto the upper surface of the spin base 27c. FIG. 6A and FIG. 6B show examples of the former case. When the spin chuck 27a is a gripping-type chuck, the plurality of chuck pins 27b correspond to the substrate holder. When the spin chuck 27a is a vacuum-type chuck, the spin base 27c corresponds to the substrate holder.

The sulfuric acid-ozone etching unit 2B includes a sulfuric acid nozzle 28a that supplies sulfuric acid to the upper surface of the substrate W being held by the spin chuck 27a, and a rinse liquid nozzle 29a that supplies rinse liquid to the upper surface of the substrate W that is being held by the spin chuck 27a. FIG. 6A shows an example where the rinse liquid is pure water (DIW). The rinse liquid is not limited to pure water and may instead be IPA (isopropyl alcohol), carbonated water, electrolytic ion water, hydrogen water, ozone water or hydrochloric acid water at dilute concentration (for example, about 10 to 100 ppm), or ammonium hydroxide at dilute concentration (for example, about 10 to 100 ppm).

As shown in FIG. 6A, the sulfuric acid-ozone etching unit 2B includes a sulfuric acid tube 28b that guides sulfuric acid toward the sulfuric acid nozzle 28a, and a sulfuric acid valve 28c that opens and closes between an open state in which sulfuric acid flows from the sulfuric acid tube 28b to the sulfuric acid nozzle 28a, and a closed state in which sulfuric acid does not flow from the sulfuric acid tube 28b to the sulfuric acid nozzle 28a. When the sulfuric acid valve 28c is opened, sulfuric acid is discharged continuously downward from the discharge port of the sulfuric acid nozzle 28a.

The sulfuric acid-ozone etching unit 2B includes a rinse liquid tube 29b that guides rinse liquid toward the rinse liquid nozzle 29a, and a rinse liquid valve 29c that opens and closes between an open state in which rinse liquid flows from the rinse liquid tube 29b to the rinse liquid nozzle 29a, and a closed state in which rinse liquid does not flow from the rinse liquid tube 29b to the rinse liquid nozzle 29a. When the rinse liquid valve 29c is opened, the rinse liquid is continuously discharged downward from the discharge port of the rinse liquid nozzle 29a.

The sulfuric acid nozzle 28a may be a scan nozzle that can move the location of impact of the processing liquid on the substrate W within the upper or lower surface of the substrate W, or it may be a fixed nozzle that cannot move the location of impact of the processing liquid on the substrate W. The same applies to the rinse liquid nozzle 29a. FIG. 6A shows an example in which the sulfuric acid nozzle 28a is a scan nozzle and the rinse liquid nozzle 29a is a fixed nozzle.

The sulfuric acid nozzle 28a is connected to a nozzle actuator 28e that moves the sulfuric acid nozzle 28a in either or both the vertical direction and horizontal direction. The sulfuric acid nozzle 28a extends downward from the tip of the nozzle arm 28d which extends horizontally. The nozzle actuator 28e is connected to the sulfuric acid nozzle 28a via the nozzle arm 28d. By moving the nozzle arm 28d, the nozzle actuator 28e moves the sulfuric acid nozzle 28a horizontally between a processing position where sulfuric acid discharged from the sulfuric acid nozzle 28a is supplied onto the upper surface of the substrate W, and a standby position where the sulfuric acid nozzle 28a is positioned around the spin chuck 27a in a plan view.

The sulfuric acid-ozone etching unit 2B includes a cylindrical processing cup 30 that blocks liquid that has scattered from the substrate W being held by the spin chuck 27a. The processing cup 30 includes a plurality of guards 31 that block liquid scattered outward from the substrate W, a plurality of cups 32 that block the liquid guided downward by the plurality of guards 31, and a cylindrical outer wall 33 surrounding the plurality of guards 31 and the plurality of cups 32. FIG. 6A shows an example where two guards 31 and two cups 32 are provided, and one cup 32 is integral with one guard 31.

The sulfuric acid-ozone etching unit 2B includes a guard raising/lowering actuator 34 that individually raises and lowers the plurality of guards 31. The guard raising/lowering actuator 34 positions the guard 31 at a desired position in a range between the upper position and lower position. The upper position is a position such that the upper end of the guard 31 is situated higher than the holding position where the substrate W held by the spin chuck 27a is positioned. The lower position is a position such that the upper end of the guard 31 is situated lower than the holding position. The upper end of the guard 31 surrounds the substrate W and spin base 27c, in a plan view.

When processing liquid is supplied to the substrate W while the spin chuck 27a is rotating, the processing liquid supplied to the substrate W is shaken off from the substrate W. When the processing liquid is supplied to the substrate W, the upper end of at least one guard 31 is situated higher than the substrate W. The processing liquid, such as chemical solution or rinse liquid discharged from the substrate W, is therefore blocked by one or more guards 31, and is guided into the cup 32 corresponding to the guard 31.

The exhaust port 21a is formed at the bottom portion of the chamber 22. The exhaust port 21a is coupled with an exhaust device via the discharge tube 21b. The ozone gas supply port 19a is formed at the top portion of the chamber 22. The ozone gas supply port 19a is connected to the ozone gas tube 19b and inert gas tube 20a. Gas flowing out from the ozone gas supply port 19a is supplied into the chamber 22. This causes the interior of the chamber 22 to be filled with gas such as ozone gas supplied from the ozone gas supply port 19a, where it is supplied to the substrate W disposed in the chamber 22.

As shown in FIG. 6B, the sulfuric acid-ozone etching unit 2B includes a lamp 35 as an example of a heater to heat the substrate W being held by the spin chuck 27a. The sulfuric acid-ozone etching unit 2B also includes a lamp actuator 35a which moves the lamp 35 horizontally between a processing position where light is emitted by the lamp 35 toward the upper surface of the substrate W, and a standby position where the lamp 35 is positioned around the spin chuck 27a, in a plan view. By rotating the substrate W by the spin chuck 27a while moving the lamp 35 horizontally with the lamp actuator 35a, it is possible to uniformly heat the entire substrate W.

When carrying out the sulfuric acid-ozone etching step, the hand Hc moves out from the sulfuric acid-ozone etching unit 2B through the outlet/inlet port 24 after the center robot CR has placed the substrate W on the spin chuck 27a (see FIG. 4A). The outlet/inlet port 24 is then closed by the door 25. When the substrate W is placed on the spin chuck 27a, the spin chuck 27a holds the substrate W with the plurality of chuck pins 27b and rotates the substrate W with the electric motor 27d. The guard raising/lowering actuator 34 raises at least one of the guards 31 from the lower position to the upper position.

After the substrate W has been held by the spin chuck 27a, the sulfuric acid valve 28c is opened while the spin chuck 27a is rotating, and discharge of sulfuric acid through the sulfuric acid nozzle 28a is initiated. This causes sulfuric acid to be supplied to the entirety of the upper surface of the substrate W, as shown in FIG. 6B. After the entirety of the upper surface of the substrate W has been covered by a liquid film of sulfuric acid, a paddle step may be carried out, in which fresh sulfuric acid supply to the substrate W is interrupted and the state in which the entire upper surface of the substrate W is covered with the liquid film of sulfuric acid is maintained while the substrate W is stationary or rotating at low speed (such as 30 rpm or lower).

After the entirety of the upper surface of the substrate W has been covered with the liquid film of sulfuric acid, ozone gas is supplied into the chamber 22 through the ozone gas supply port 19a while discharging the gas in the chamber 22 through the exhaust port 21a. In addition, the distance from the rotational axis A1 of the substrate W to the lamp 35 is changed while causing the lamp 35 to emit light, with the entirety of the upper surface of the substrate W covered by the liquid film of sulfuric acid. The ozone gas in the chamber 22 dissolves into the liquid film of sulfuric acid covering the entirety of the upper surface of the substrate W. The SOM is thereby supplied to the upper surface of the substrate W. Since the lamp 35 is releasing heat, the substrate W and SOM are uniformly heated. The sulfuric acid-ozone etching step is carried out in this manner.

When the substrate W is stationary with the entirety of the upper surface of the substrate W covered by the liquid film of sulfuric acid, the sulfuric acid remains on the upper surface of the substrate W without moving, or essentially without moving, with respect to the upper surface of the substrate W. This also applies when the substrate W has been rotated at low speed with the entirety of the upper surface of the substrate W covered with the liquid film of sulfuric acid. The entirety of the upper surface of the substrate W is thus kept in a state covered with the liquid film of sulfuric acid. A film thickness-reducing step may be carried out, in which the thickness of the same liquid film is reduced while the entirety of the upper surface of the substrate W is covered by the liquid film of sulfuric acid, by increasing the rotational speed of the substrate W before or after the substrate W is stationary or rotated at low speed. This allows the concentration of ozone in the sulfuric acid to be increased while shortening the time for the ozone dissolved in the sulfuric acid to reach the upper surface of the substrate W.

When a predetermined time period has elapsed after supply of sulfuric acid has been initiated, the gas in the chamber 22, such as ozone gas, is discharged through the exhaust port 21a and the gas other than ozone gas, such as inert gas, is supplied into the chamber 22 through the ozone gas supply port 19a. Further, the emission of the light from the lamp 35 is stopped. The rinsing step in which rinse liquid is supplied to the substrate W is carried out in this state. Specifically, the sulfuric acid valve 28c is closed when the sulfuric acid valve 28c is open. With the spin chuck 27a rotating the substrate W and the entirety of the upper surface of the substrate W covered by the liquid film of sulfuric acid, the rinse liquid valve 29c is opened and discharge of the rinse liquid through the rinse liquid nozzle 29a is initiated. This allows the rinse liquid to be supplied to the entirety of the upper surface of the substrate W, so that SOM is washed away from the substrate W.

When a prescribed time period has elapsed after initiating supply of the rinse liquid, the rinse liquid valve 29c is closed. A drying step is then carried out in which the substrate W is dried by high-speed rotation of the substrate W. Specifically, with discharge of the rinse liquid through the rinse liquid nozzle 29a stopped, the electric motor 27d accelerates the substrate W in the rotational direction, and rotates the substrate W at a high rotational speed (such as several thousand rpm) that is higher than the rotational speed of the substrate W during the period from the sulfuric acid-ozone etching step to the rinsing step. This causes the liquid to be removed from the substrate W, and the substrate W is dried. When a prescribed time period has elapsed after initiating high-speed rotation of the substrate W, the electric motor 27d stops the rotation.

After rotation of the substrate W has stopped, all of the guards 31 are positioned at the lower position. In this state, the outlet/inlet port 24 is opened, and the center robot CR causes the hand Hc to enter into the sulfuric acid-ozone etching unit 2B. The center robot CR moves the hand Hc, thereby supporting the substrate W on the spin chuck 27a with the hand Hc. The center robot CR then moves the hand Hc out of the sulfuric acid-ozone etching unit 2B through the outlet/inlet port 24. The substrate W is thus carried out from the sulfuric acid-ozone etching unit 2B.

The multi-etching unit 2C that carries out both the ozone gas etching step and sulfuric acid-ozone etching step will now be described.

FIG. 7A and FIG. 7B are schematic diagrams showing a vertical cross-section of the multi-etching unit 2C. The multi-etching unit 2C includes the chamber 22, spin chuck 27a, sulfuric acid nozzle 28a, rinse liquid nozzle 29a and processing cup 30, as shown in FIG. 6A and FIG. 6B. As shown in FIG. 7A and FIG. 7B, the multi-etching unit 2C also includes a hot plate 36 as an example of a heater that heats the substrate W held by the spin chuck 27a, a hood 37 that forms the accommodating space SP1, and a hood actuator 37a that moves the hood 37 vertically between a housed position where the substrate W is disposed inside the hood 37, and a standby position where the substrate W is disposed outside of the hood 37.

The hot plate 36 is disposed between the substrate W and the spin base 27c. The hot plate 36 includes a heating body (not shown) that generates Joule heat when energized, and an outer case that houses the heating body. The heating body and outer case are situated below the substrate W. The heating body is connected to wiring (not shown) that supplies electric power to the heating body. The temperature of the heating body is changed by a controller 3 (see FIG. 4A). When the controller 3 causes the heating body to release heat, the entire substrate W becomes uniformly heated.

The outer case of the hot plate 36 includes a discoid base portion disposed below the substrate W, and a plurality of hemispherical protrusion portions protruding upward from the upper surface of the base portion. The upper surface of the base portion is parallel with the lower surface of the substrate W and has an outer diameter that is smaller than the diameter of the substrate W. The plurality of protrusion portions contact the lower surface of the substrate W at locations upwardly away from the upper surface of the base portion. The plurality of protrusion portions are disposed at a plurality of locations within the upper surface of the base portion, so that the substrate W is supported horizontally. The substrate W is supported horizontally in a state in which the lower surface of the substrate W is separated upward from the upper surface of the base portion.

The hot plate 36 is supported horizontally by a support shaft 36s extending downward from the central portion of the hot plate 36. The plurality of chuck pins 27b are disposed around the hot plate 36. The center line of the hot plate 36 is disposed on the rotational axis A1 of the substrate W. The hot plate 36 does not rotate even when the spin chuck 27a rotates. The outer diameter of the hot plate 36 is smaller than the diameter of the substrate W.

The hot plate 36 is able to move up and down with respect to the spin base 27c. The hot plate 36 is connected to a plate raising/lowering actuator 36a via the support shaft 36s. The plate raising/lowering actuator 36a vertically raises and lowers the hot plate 36 between the upper position and lower position (the positions shown in FIG. 7A and FIG. 7B). The upper position is the contact position where the hot plate 36 contacts with the lower surface of the substrate W. The lower position is an adjacent position where the hot plate 36 is situated between the lower surface of the substrate W and the upper surface of the spin base 27c, and separated from the substrate W.

The hot plate 36 is an example of a substrate holder. The plate raising/lowering actuator 36a positions the hot plate 36 at a desired position in a range between the upper position and the lower position. When the hot plate 36 rises to the upper position with the substrate W supported by the plurality of chuck pins 27b and gripping of the substrate W released, the plurality of protrusion portions of the hot plate 36 contact with the lower surface of the substrate W, so that the substrate W is supported by the hot plate 36. The substrate W is then raised up by the hot plate 36, and is separated upward from the plurality of chuck pins 27b. When the hot plate 36 falls to the lower position in this state, the substrate W on the hot plate 36 is placed on the plurality of chuck pins 27b, and the hot plate 36 retreats downward from the substrate W. In this way, the substrate W is transferred between the plurality of chuck pins 27b and the hot plate 36.

The hood 37 is disposed in the chamber 22. The hood 37 is disposed above the spin chuck 27a. The hood 37 includes a discoid plate portion 37p held horizontally, and a cylinder portion 37t which extends downward from the outer periphery of the plate portion 37p. The space inside the cylinder portion 37t corresponds to the accommodating space SP1. The center of the plate portion 37p is disposed on the rotational axis A1 of the substrate W. The inner diameter of the cylinder portion 37t is larger than the outer diameter of the spin base 27c. The outer diameter of the cylinder portion 37t is smaller than the inner diameter of the upper end of the guard 31.

When the hood actuator 37a places the hood 37 at the housed position shown in FIG. 7B, the lower end of the cylinder portion 37t of the hood 37 is situated lower than the substrate W being held by the spin chuck 27a, and the substrate W becomes surrounded by the cylinder portion 37t. When the hood actuator 37a places the hood 37 at the standby position shown in FIG. 7A, the lower end of the cylinder portion 37t of the hood 37 is situated higher than the substrate W being held by the spin chuck 27a. This also applies when the hot plate 36 is holding the substrate W instead of the spin chuck 27a. The scan nozzle of the sulfuric acid nozzle 28a can move horizontally between the processing position and the standby position while the hood 37 is disposed at the standby position.

The ozone gas supply port 19a is opened at the lower surface of the plate portion 37p of the hood 37. FIG. 7A shows an example where a plurality of ozone gas supply ports 19a are opened at the lower surface of the plate portion 37p. In this example, the ozone gas tube 19b and inert gas tube 20a are connected to the plurality of ozone gas supply ports 19a. The exhaust port 21a is situated lower than the substrate W being held by the spin chuck 27a. In the example shown in FIG. 7A and FIG. 7B, the exhaust port 21a is opened at the inner peripheral surface of the cylindrical outer wall 33 of the processing cup 30.

When carrying out the ozone gas etching step, ozone gas is discharged to the ozone gas supply port 19a while the hood 37 is positioned at the housed position and the spin chuck 27a or hot plate 36 is holding the substrate W, causing the substrate W to be heated on the hot plate 36. The space between the substrate W and the hood 37 thus fills with ozone gas. Inert gas is subsequently discharged into the ozone gas supply port 19a. The ozone gas is discharged from between the substrate W and hood 37 by the inert gas, and is pushed out from the chamber 22 through the exhaust port 21a.

When carrying out the sulfuric acid-ozone etching step, the hood 37 is moved to the standby position with the substrate W being held by the spin chuck 27a or hot plate 36. When the substrate W is held by the spin chuck 27a, the spin chuck 27a may be either rotated or not be rotated. Sulfuric acid is discharged through the sulfuric acid nozzle 28a in this state. This forms a liquid film of sulfuric acid covering the entire upper surface of the substrate W. Discharge of sulfuric acid through the sulfuric acid nozzle 28a is then interrupted, and the sulfuric acid nozzle 28a is retracted from between the substrate W and hood 37.

After the sulfuric acid nozzle 28a has been retracted from between the substrate W and hood 37, the hood 37 is lowered from the standby position to the housed position. Ozone gas is discharged through the ozone gas supply port 19a in this state. If the hot plate 36 had previously stopped heat release, heat release is resumed in the hot plate 36. Ozone gas thus dissolves into the liquid film of sulfuric acid covering the entire upper surface of the substrate W, and SOM is supplied to the entire upper surface of the substrate W.

After the SOM has been supplied to the entire upper surface of the substrate W, inert gas is discharged through the ozone gas supply port 19a, and ozone gas is discharged from between the substrate W and hood 37. When the substrate W is being held by the hot plate 36, the substrate W is moved to the plurality of chuck pins 27b and the spin chuck 27a is made to rotate the substrate W. The rinse liquid is discharged through the rinse liquid nozzle 29a shown in FIG. 7A in this state, and the SOM adhering to the substrate W is washed away. The spin chuck 27a is then made to rotate the substrate W at high speed to remove the liquid from the substrate W. The substrate W is thus dried.

Next, the advantages of the embodiment will be described.

For this embodiment, ozone gas is supplied as etching gas to the amorphous carbon film AC. This allows the amorphous carbon film AC to be etched without wetting the front surface of the substrate W as the device-forming surface. It is also possible to increase the etching rate of the amorphous carbon film AC since ozone gas is supplied to the amorphous carbon film AC while heating the substrate W. After the ozone gas as etching gas has been supplied to the amorphous carbon film AC, the ozone-containing sulfuric acid, as the etching solution, i.e., the sulfuric acid containing dissolved ozone gas as dissolved gas, is supplied to the amorphous carbon film AC. This allows further etching of the amorphous carbon film AC.

The etching rate of the amorphous carbon film AC with supply of ozone-containing sulfuric acid is lower than the etching rate of the amorphous carbon film AC with supply of ozone gas. It is therefore possible to increase the etching rate, compared to when no ozone gas etching step is carried out. Moreover, the total amount of etching of the amorphous carbon film AC (the total of the amount of etching of the amorphous carbon film AC in the ozone gas etching step and the amount of etching of the amorphous carbon film AC in the sulfuric acid-ozone etching step) can be more precisely adjusted, in comparison to a case where the sulfuric acid-ozone etching step is carried out before the ozone gas etching step. In addition, the environmental load can be reduced, in comparison to a case where SPM (a mixture of Sulfuric Acid-Hydrogen Peroxide Mixture) is used instead of ozone-containing sulfuric acid.

According to this embodiment, ozone-containing sulfuric acid is supplied to the substrate W while heating the substrate W. This allows the ozone-containing sulfuric acid to be heated. Ozone-containing sulfuric acid generates peroxodisulfate ions in the ozone-containing sulfuric acid. The peroxodisulfate ions are converted to sulfate ion radicals which have strong oxidizing power. Adding thermal energy to the ozone-containing sulfuric acid can help promote conversion to sulfate ion radicals. This can increase the etching rate of the amorphous carbon film AC when ozone-containing sulfuric acid has been supplied.

According to this embodiment, the surface of the amorphous carbon film AC is continuously removed by supplying ozone gas as etching gas to the substrate W. The ozone molecules contained in the ozone gas are converted not only to radicals such as oxygen radicals but also to oxygen molecules. Oxygen molecules may be produced by chemical reaction between the radicals and the amorphous carbon film AC. Oxygen molecules oxidize the surface of the amorphous carbon film AC exposed by etching of the amorphous carbon film AC, thereby forming the oxide film AC1 of the amorphous carbon film AC in the surface layer of the amorphous carbon film AC. The ozone-containing sulfuric acid which contains sulfate ion radicals etches not only the amorphous carbon film AC but also the oxide film AC1 of the amorphous carbon film AC. It is therefore possible to etch the amorphous carbon film AC by ozone-containing sulfuric acid even when the oxide film AC1 of the amorphous carbon film AC has been formed.

The cycle including the ozone gas etching step and the sulfuric acid-ozone etching step is repeated a plurality of times for this embodiment. Specifically, ozone-containing sulfuric acid as etching solution is supplied to the substrate W after ozone gas as etching gas has been supplied to the substrate W. Ozone gas as etching gas is then supplied to the substrate W, and ozone-containing sulfuric acid as etching solution is supplied to the substrate W. The oxide film AC1 of the amorphous carbon film AC will sometimes lower the etching rate of the amorphous carbon film AC during the ozone gas etching step. Carrying out the aforementioned cycle a plurality of times can remove the oxide film AC1 of the amorphous carbon film AC, thus helping to prevent such lowering of the etching rate.

According to this embodiment, the substrate W is held horizontally with the front surface of the substrate W facing upward, and the accommodating space SP1 in which the substrate W is disposed is filled with ozone gas. Sulfuric acid is discharged toward the front surface of the substrate W in this state. This forms a liquid film of sulfuric acid covering the entire front surface of the substrate W. The ozone gas in the accommodating space SP1 dissolves into the liquid film of sulfuric acid. This forms a liquid film of the ozone-containing sulfuric acid covering the entire front surface of the substrate W. Moreover, since ozone gas is dissolved in the sulfuric acid that is contacting with the substrate W, instead of dissolving ozone gas into the sulfuric acid before it contacts with the substrate W, it is possible to shorten the time until the oxidizing agent, such as ozone molecules, reaches the amorphous carbon film AC.

According to this embodiment, the ozone-containing sulfuric acid is supplied to the entire front surface of the substrate W while the ozone-containing sulfuric acid remains on the front surface of the substrate W. In other words, the ozone-containing sulfuric acid is supplied to the entire front surface of the substrate W while discharging no or almost no ozone-containing sulfuric acid from the substrate W. The ozone-containing sulfuric acid generates oxidizing agents such as peroxodisulfate ions and sulfate ion radicals. When ozone-containing sulfuric acid is discharged from the substrate W, such oxidizing agents may be discharged from the substrate W before reacting with the amorphous carbon film AC. By causing the ozone-containing sulfuric acid to remain on the front surface of the substrate W, it is possible to reduce such discharge of oxidizing agents from the substrate W before reaction with the amorphous carbon film AC.

Next, other embodiments will be described.

Supply of ozone gas to the substrate W may be stopped before the oxide film AC1 of the amorphous carbon film AC is formed in the ozone gas etching step.

The ozone-containing sulfuric acid may be supplied to the substrate W without heating the substrate W in the sulfuric acid-ozone etching step.

Instead of dissolving ozone gas in the sulfuric acid which is contacting the substrate W, sulfuric acid in which ozone gas is dissolved may be supplied to the substrate W before contact with the substrate W. For example, ozone gas may be dissolved in the sulfuric acid at any location in a path through which sulfuric acid passes from a tank storing the sulfuric acid to the substrate W.

In the sulfuric acid-ozone etching step, instead of maintaining the state in which the entire upper surface of the substrate W is covered by a liquid film of sulfuric acid while stopping supply of fresh sulfuric acid to the substrate W, the state in which the entire upper surface of the substrate W is covered by a liquid film of sulfuric acid may be maintained while adding fresh sulfuric acid to the upper surface of the substrate W. This applies to discharge of SOM, which corresponds to ozone-containing sulfuric acid, toward the substrate W.

The substrate processing apparatus 1 is not restricted to an apparatus to process a disc-shaped substrate W, and may be an apparatus to process a polygonal substrate W.

Two or more arrangements among all the arrangements described above may be combined. Two or more steps among all the steps described above may be combined.

The embodiments of the present invention are described in detail above, however, these are just detailed examples used for clarifying the technical contents of the present invention, and the present invention should not be limitedly interpreted to these detailed examples, and the spirit and scope of the present invention should be limited only by the claims appended hereto.

This application claims the benefit of priority to Japanese Patent Application No. 2023-202325 filed on November 30, 2023. The entire contents of this application are hereby incorporated herein by reference.

## Claims

1. A substrate processing method comprising:
an ozone gas etching step of etching an amorphous carbon film (AC) in a state in which a front surface of a substrate (W) is dry by supplying ozone gas as etching gas to the amorphous carbon film (AC) formed on the front surface of the substrate (W) while heating the substrate (W), and
a sulfuric acid-ozone etching step of etching the amorphous carbon film (AC) by supplying, after the ozone gas is supplied to the amorphous carbon film (AC), the amorphous carbon film (AC) with ozone-containing sulfuric acid that is sulfuric acid in which ozone gas as dissolved gas is dissolved.

2. The substrate processing method according to claim 1, wherein the sulfuric acid-ozone etching step includes a step of supplying the ozone-containing sulfuric acid to the amorphous carbon film (AC) while heating the substrate (W).

3. The substrate processing method according to claim 2, wherein
the ozone gas etching step includes a step of forming an oxide film (AC1) of the amorphous carbon film (AC) in a surface layer of the amorphous carbon film (AC) by oxidizing a surface of the amorphous carbon film (AC) which has been exposed by etching of the amorphous carbon film (AC) and
the sulfuric acid-ozone etching step includes a step of etching the oxide film (AC1) of the amorphous carbon film (AC) by supplying the ozone-containing sulfuric acid to the amorphous carbon film (AC).

4. The substrate processing method according to claim 3, wherein a cycle including the ozone gas etching step and the sulfuric acid-ozone etching step is repeated a plurality of times.

5. The substrate processing method according to any one of claims 1 to 4, wherein the sulfuric acid-ozone etching step includes a step of forming a liquid film of the ozone-containing sulfuric acid covering the entire front surface of the substrate (W), by discharging sulfuric acid toward the front surface of the substrate (W) in a state in which the substrate (W) is held horizontally with the front surface of the substrate (W) facing upward, and an accommodating space (SP1) in which the substrate (W) is placed is filled with ozone gas.

6. The substrate processing method according to claim 5, wherein the sulfuric acid-ozone etching step includes a step of causing the ozone-containing sulfuric acid to remain on the front surface of the substrate (W) while maintaining a state in which the entire front surface of the substrate (W) is covered with the liquid film of the ozone-containing sulfuric acid.

7. A substrate processing apparatus comprising:
a heater (35,36) that heats a substrate (W) having an amorphous carbon film (AC) formed on a front surface of the substrate (W),
an ozone gas supply port (19a) that etches the amorphous carbon film (AC) while the front surface of the substrate (W) is dry by supplying ozone gas as etching gas to the amorphous carbon film (AC) formed on the front surface of the substrate (W), and
a nozzle (28a) that etches the amorphous carbon film (AC) by supplying, after the ozone gas is supplied to the amorphous carbon film (AC), the amorphous carbon film (AC) formed on the front surface of the substrate (W) with ozone-containing sulfuric acid that is sulfuric acid in which ozone gas as dissolved gas is dissolved.

8. The substrate processing apparatus according to claim 7, wherein the nozzle (28a) supplies the ozone-containing sulfuric acid to the amorphous carbon film (AC) when the heater (35,36) is heating the substrate (W).

9. The substrate processing apparatus according to claim 8, wherein:
the ozone gas supply port (19a) forms an oxide film (AC1) of the amorphous carbon film (AC) in a surface layer of the amorphous carbon film (AC) by oxidizing a surface of the amorphous carbon film (AC) which has been exposed by etching of the amorphous carbon film (AC), and
the nozzle (28a) etches the oxide film (AC1) of the amorphous carbon film (AC) by supplying the ozone-containing sulfuric acid to the amorphous carbon film (AC).

10. The substrate processing apparatus according to claim 9, wherein the ozone gas supply port (19a) and nozzle (28a) carry out a cycle, which includes etching of the amorphous carbon film (AC) by the ozone gas and etching of the amorphous carbon film (AC) by the ozone-containing sulfuric acid, a plurality of times.

11. The substrate processing apparatus according to any one of claims 7 to 10, wherein the nozzle (28a) forms a liquid film of the ozone-containing sulfuric acid covering the entire front surface of the substrate (W) by discharging sulfuric acid toward the front surface of the substrate (W) in a state in which the substrate (W) is held horizontally with the front surface of the substrate (W) facing upward, and an accommodating space (SP1) in which the substrate (W) is placed is filled with ozone gas.

12. The substrate processing apparatus according to claim 11, wherein the nozzle (28a) causes the ozone-containing sulfuric acid to remain on the front surface of the substrate (W) while maintaining a state in which the entire front surface of the substrate (W) is covered with the liquid film of the ozone-containing sulfuric acid.
